# FASCICULE DE BREVET EUROPEEN

(11) **EP 3 451 181 B1**
(45) Date de publication et mention de la délivrance du brevet: **20.10.2021**
(21) Numéro de dépôt: 18189455.1
(22) Date de dépôt: 17.08.2018
(51) Int. Cl.: G06F 13/40

(54) **CIRCUIT DE PROTECTION CONTRE LES HAUTES TENSIONS POUR RÉCEPTEUR USB TYPE C**
SCHUTZSCHALTKREIS GEGEN HOHE SPANNUNGEN FÜR EINEN USB-EMPFÄNGER VOM TYP C
CIRCUIT FOR PROTECTING AGAINST HIGH VOLTAGES FOR USB TYPE C RECEIVER

(30) Priorité: 01.09.2017 FR 1758085
(43) Date de publication de la demande: 06.03.2019
(73) Titulaire: STMicroelectronics (Rousset) SAS, 13790 Rousset (FR)
(72) Inventeur: FULCHERI, Patrick, 06410 BIOT (FR); OKU, Kenichi, 06130 GRASSE (FR)
(74) Mandataire: Casalonga

(56) Documents cités:
- CN-A- 106 300 314
- US-A1- 2017 155 214

## Description

Des modes de réalisation de l'invention concernent les dispositifs de bus universel en série (« Universal Serial Bus » : USB en anglais), notamment les dispositifs de bus universel en série compatibles avec le standard USB 3.1 supportant le mode délivrance de puissance en USB Power Delivery (« USB Power Delivery » PD mode en anglais) et comportant les connecteurs réversibles qui n'imposent pas d'orientation de branchement, communément connus par l'homme du métier sous le nom du type C, plus particulièrement la protection contre des hautes tensions, typiquement des tensions supérieures à 5 volts et pouvant aller jusqu'à 20 volts, susceptibles d'être présentes sur les broches de configuration de canal des dispositifs récepteurs USB de type C.

Théoriquement, les dispositifs USB 3.1 du type C supportant le mode de délivrance de puissance en USB PD permettent de débiter jusqu'à 10 Go/s et de délivrer jusqu'à 100 W de puissance sur une tension maximale de 20 V et un courant maximal de 5 A. La puissance à délivrer entre deux dispositifs USB 3.1 PD du type C est négociable par l'intermédiaire de contrôleurs spécifiques et l'alimentation électrique peut avantageusement être bidirectionnelle entre différents dispositifs USB 3.1 du type C.

D'une façon générale, un câble USB type C est conçu pour être couplé et établir une ligne d'alimentation et de communication entre un dispositif USB PD type C dit « source » et un dispositif USB PD type C dit « récepteur ».

Le dispositif source est capable d'adapter la valeur de la tension d'alimentation dans une plage de 0 à 20 volts.

De fortes tensions, typiquement comprises entre 5 volts et 20 volts peuvent être présentes sur les broches de configuration de canal du connecteur du récepteur.

Il est par conséquent recommander par la norme USB de connecter sur ces broches un circuit de protection contre ces hautes tensions, de façon à protéger des récepteurs qui ne sont pas capables de supporter de telles tensions sur les broches de configuration de canal.

Actuellement il est proposé par la norme de connecter des transistors haute tension entre les broches de configuration de canal et l'étage de détection de courant et l'étage de détection de connexion. Ces transistors sont conçus pour limiter alors la tension au niveau de ces étages à environ 2,7 volts pour une tension en entrée d'environ 25 volts.

Cependant pour certaines applications, ces transistors sont trop coûteux et/ou trop encombrants, en particulier pour des applications très simples consistant par exemple à charger un récepteur, par exemple un téléphone intelligent (smartphone), une tablette ou un ordinateur portable avec un chargeur USB type C.

Aussi dans certains produits, notamment à bas coût, ces protections sont purement et simplement omises, ce qui impacte négativement la fiabilité de ces produits et peut les rendre non conformes à la norme USB 3.1 PD.

Il existe donc un besoin de proposer un circuit de protection contre les hautes tensions présentes éventuellement sur les bornes de configuration de canal du récepteur qui soit simple à mettre en œuvre, peu coûteux et d'un encombrement faible.

La norme USB 3.1 recommande par ailleurs que le récepteur soit équipé sur les broches de configuration de canal d'un circuit résistif de tirage vers le bas (résistance de tirage vers le bas : résistance de « pull down »), chaque résistance de tirage vers le bas ayant une valeur nominale, typiquement 5100 ohms, à plus ou moins 10% près.

Ces résistances de pull down permettent au dispositif source, par exemple un chargeur, de détecter qu'on a effectivement une connexion avec un dispositif récepteur et qu'il n'existe pas de non-conformité de ce dispositif récepteur. Une telle non-conformité peut par exemple résulter d'une batterie défectueuse du dispositif récepteur, par exemple une batterie complètement déchargée ou une batterie en mode de sécurité qui n'est pas capable de fournir une tension minimale de fonctionnement.

Pour détecter une éventuelle non-conformité, le dispositif source délivre sur les broches de configuration de canal un courant ayant une valeur prédéfinie et la tension mesurée sur ces broches doit se situer dans une plage prédéfinie compte-tenu de la valeur prédéfinie de la résistance de pull down.

L'étendue de la protection est définie par les revendications annexées.

Selon un mode de réalisation, il est proposé de configurer ce circuit résistif de tirage vers le bas de sorte qu'il forme un circuit de protection contre les hautes tensions tout en assurant la fonction de circuit de tirage vers le bas recommandée par la norme USB type C.

Selon un aspect, il est proposé un dispositif récepteur USB type C, comprenant un port comportant une entrée de configuration de canal, un circuit résistif de tirage vers le bas couplé entre l'entrée de configuration de canal et une broche de masse et un étage de protection contre des hautes tensions sur l'entrée de configuration de canal.

L'étage de protection comprend un module résistif couplé entre l'entrée de configuration de canal et la borne de masse et configuré pour former à la fois un diviseur de tension et le circuit résistif de tirage vers le bas.

Ainsi, le module résistif de l'étage de protection remplit deux fonctions, à savoir une fonction de diviseur de tension qui permet de limiter la tension à la sortie du diviseur de tension (et donc de protéger les composants situés en aval de cet étage de protection, contre des hautes tensions, typiquement supérieures à 5 volts, présentes sur l'entrée de configuration de canal) et d'autre part la fonction de circuit résistif de tirage vers le bas spécifié par la norme USB.

Comme indiqué ci-avant, la valeur résistive du circuit résistif de tirage vers le bas est égale à une valeur nominale, typiquement 5100 ohms, à plus ou moins 10% près.

Selon un mode de réalisation, l'entrée de configuration de canal comprend deux broches de configuration de canal.

Le module résistif comprend alors deux ponts résistifs diviseurs de tension respectivement couplés entre les deux broches de configuration de canal et la borne de masse.

Chaque pont résistif diviseur de tension comprend un premier élément résistif couplé à la borne de configuration de canal correspondante et un deuxième élément résistif couplé entre le premier élément résistif et la borne de masse.

Le nœud commun entre le premier élément résistif et le deuxième élément résistif forme une sortie du pont résistif diviseur de tension.

La valeur résistive du premier élément résistif est égale à ladite valeur nominale à plus ou moins 10% près tandis que la valeur résistive du deuxième élément résistif est non nulle et que la somme des valeurs résistives des deux éléments résistifs est égale à la valeur nominale à plus ou moins 10% près.

Ainsi, la valeur résistive entre une broche de configuration de canal et la broche de masse est bien égale à la valeur nominale (5100 ohms) à plus ou moins 10% près.

Par ailleurs, un module de mesure de tension peut être avantageusement couplé à la sortie de chaque pont diviseur de tension. Et, lorsque ce module de mesure de tension n'est pas alimenté, le deuxième élément résistif de chaque pont résistif diviseur de tension peut alors être considéré comme court-circuité. Cela étant, ceci ne pose pas un problème vis-à-vis de la norme USB car dans ce cas, la résistance connectée entre la broche de configuration de canal correspondante et la broche de masse est alors formée du premier élément résistif dont la valeur résistive est égale à la valeur nominale (5100 ohms) à plus ou moins 10% près.

On voit donc que de nombreuses valeurs de résistance sont possibles pour former le ou les ponts diviseurs.

Cela étant, le facteur de division entre la tension présente sur une broche de configuration de canal et la tension en sortie du pont résistif diviseur de tension est égal au rapport entre la valeur résistive du deuxième élément résistif et la somme des valeurs résistives de ces deux éléments résistifs.

Et, pour certaines valeurs de résistance, ce facteur de division peut être trop faible, ce qui peut alors poser un problème de précision pour la mesure de la tension en sortie du pont diviseur de tension, en particulier si l'on souhaite utiliser comme module de mesure de tension un convertisseur analogique numérique.

Aussi, selon un mode préféré de réalisation conduisant à un compromis acceptable, on pourra choisir comme valeur résistive du premier élément résistif une valeur égale à 4590 ohms et comme valeur résistive du deuxième élément résistif une valeur égale à 510 ohms.

Ceci conduit à un facteur de division égal à 1/10 ce qui permet, pour des tensions, présentes en entrée du pont diviseur de tension correspondant, égales à 20 volts de limiter la tension à 2 volts en sortie du pont diviseur, tout en respectant la norme USB en ce qui concerne les résistances de tirage vers le bas.

Par ailleurs, lorsque le module de mesure de tension comprend un convertisseur analogique numérique comportant deux entrées respectivement connectées aux deux sorties des deux ponts résistifs diviseurs de tension, les valeurs indiquées ci-dessus pour les deux éléments résistifs permettent d'utiliser avantageusement un convertisseur analogique numérique 12 bits qui est un composant largement disponible sur le marché, voire un convertisseur sur plus de 12 bits donc plus précis.

Selon un autre aspect, il est proposé un appareil électronique, par exemple un téléphone portable cellulaire, une tablette ou un ordinateur portable comprenant au moins un dispositif récepteur tel que défini ci-avant.

D'autres avantages et caractéristiques de l'invention apparaîtront à l'examen de la description détaillée de modes de réalisation, nullement limitatifs, et des dessins annexés sur lesquels :

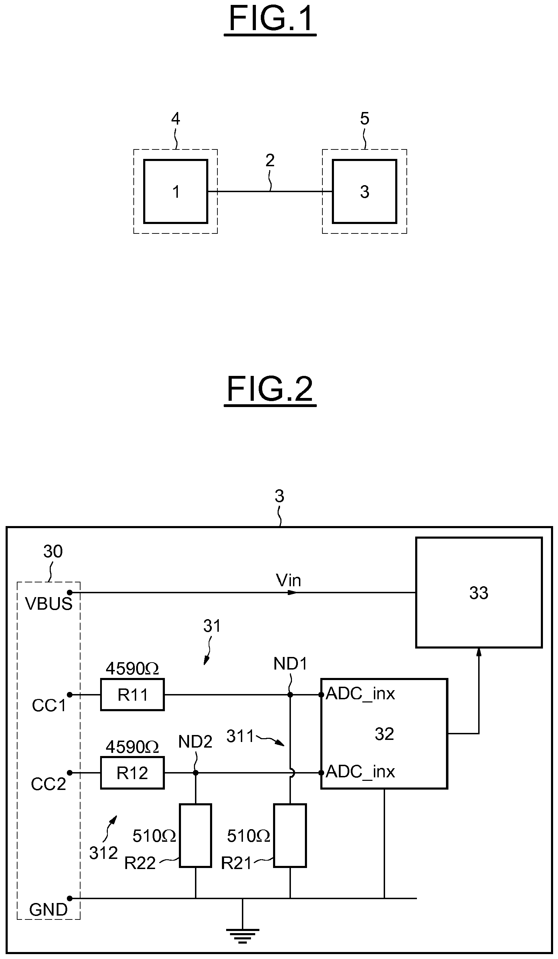

- les figures 1 et 2 illustrent schématiquement des modes de réalisation de l'invention.

La figure 1 illustre schématiquement un appareil électronique 4, ici par exemple un ordinateur bureautique ou portable, comportant au moins un dispositif source 1 USB type C capable de charger, via un câble 2 USB type C, un dispositif récepteur 3 USB type C, par exemple incorporé au sein d'un téléphone mobile cellulaire ou d'une tablette.

Le dispositif 4 pourrait être également tout simplement un chargeur capable d'être connecté sur un réseau d'alimentation, par exemple mais non limitativement un réseau 220 volts.

Comme il est classique et connu en la matière, le dispositif récepteur 3 (figure 2) comprend un connecteur ou port 30 possédant typiquement une entrée de configuration de canal ayant ici deux broches de configuration de canal CC1 et CC2, plusieurs broches de tension d'alimentation VBUS, dont une seule est représentée ici à des fins de simplification et plusieurs broches de masse GND, par exemple quatre broches de masse, dont une seule est représentée ici à des fins de simplification.

Selon la norme USB 3.1 type C, toutes les broches de même type sont symétriques par rapport au centre du connecteur 30 de sorte que le connecteur 30 n'impose pas d'orientation de branchement au connecteur de câble USB type C. Le connecteur du câble comporte une seule broche de configuration de canal qui, selon l'orientation de branchement, sera en contact soit avec la broche CC1 soit avec la broche CC2 du dispositif récepteur 3.

Selon la norme USB type C, la tension d'alimentation Vin présente sur l'entrée VBUS peut atteindre des valeurs aussi hautes que 20 volts. En conséquence, de telles valeurs élevées de tension peuvent également être présentes sur les broches de configuration de canal CC1 et CC2.

A cet égard, il est prévu un étage de protection 31 contre de telles hautes tensions, typiquement des tensions supérieures à 5 volts. Cet étage de protection 31 comprend un module résistif couplé entre l'entrée de configuration de canal, c'est-à-dire ici les deux broches CC1 et CC2, et la borne de masse GND et configuré pour former à la fois un diviseur de tension et un circuit résistif de tirage vers le bas.

Plus précisément, le module résistif comprend ici deux ponts diviseurs résistifs 311 et 312.

Le premier pont diviseur résistif 311 est couplé entre la broche de configuration de canal CC1 et la borne de masse tandis que le deuxième pont diviseur résistif 312 est couplé entre la broche de configuration de canal CC2 et la borne de masse.

Le premier pont diviseur 311 comprend un premier élément résistif R11 couplé à la broche de configuration de canal CC1 et un deuxième élément résistif R21 couplé entre le premier élément résistif R11 et la borne de masse GND.

Le nœud commun ND1 entre les deux éléments résistifs R11 et R21 forme la sortie du premier pont diviseur résistif 311.

Le deuxième pont diviseur résistif 312 comporte un premier élément résistif R12 connecté à la broche de configuration de canal CC2 et un deuxième élément résistif R22 connecté entre le premier élément résistif R12 et la borne de masse GND, le nœud commun ND2 entre ces deux éléments résistifs formant la borne de sortie de ce deuxième pont diviseur 312.

Dans cet exemple de réalisation, la valeur résistive de chacun des premiers éléments résistifs R11 et R12 est égale à 4590 ohms ce qui représente 90% de la valeur nominale de 5100 ohms prévue pour une résistance de pull down dans la norme USB.

La valeur résistive de chacun des deuxièmes éléments résistifs R21 et R22 est ici égale à 510 ohms.

De ce fait, la valeur résistive du chemin entre chaque borne de configuration de canal CCi et la borne de masse est égale à 5100 ohms.

Les exigences définies par la norme USB 3.1 en termes de résistance de tirage vers le bas (résistance de « pull down ») sont donc satisfaites.

Par ailleurs, comme on le verra plus en détail ci-après, un convertisseur analogique numérique 32 est connecté sur les sorties ND1 et ND2 des deux ponts diviseurs résistifs. Et, lorsque ce convertisseur n'est pas alimenté, les éléments résistifs R21 et R22 peuvent être considérés comme court-circuités. La valeur résistive vue alors entre chaque borne de configuration de canal CCi et la borne de masse GND est alors égale à 4590 ohms ce qui correspond à la valeur nominale de 5100 ohms moins 10%.

Par conséquent, là encore, les exigences de la norme USB 3.1 sont satisfaites en matière de résistance de pull down.

Par ailleurs, la tension présente sur le nœud de sortie NDi est égale dans cet exemple à 1/10 de la tension présente à la borne de configuration de canal correspondante CCi (la broche CC1 ou CC2 en fonction de l'orientation de branchement du connecteur du câble). En effet, ce facteur de division est égal à 510x(4590+510).

Le module résistif 31 forme donc également un circuit de protection contre les hautes tensions présentes éventuellement sur les broches de configuration de canal CC1 ou CC2.

Ainsi, même si l'on a sur la broche CC1 ou CC2 (en fonction de l'orientation de branchement du connecteur du câble) une tension de l'ordre de 20 volts, on obtiendra au nœud de sortie correspondant NDi une tension de l'ordre de 2 volts.

Par ailleurs, la norme USB 3.1 type C prévoit en permanence un courant informatif circulant à travers la broche de configuration de canal du dispositif source de façon à indiquer le courant maximal pouvant être délivré par le dispositif source USB type C.

Ce courant informatif se traduit au niveau de la broche de configuration de canal CC1 ou CC2 du dispositif récepteur 3 par une tension informative qui, lorsqu'elle est mesurée par le module 32 permet de connaître la puissance délivrée par le dispositif source 1.

Il convient de noter que la gamme de tensions admissibles délivrées par le dispositif source sur la broche de configuration de canal CC1 ou CC2 du dispositif récepteur 3 peut aller jusqu'à 2,04 volts.

Ainsi, une tension comprise entre 0,25 volt et 0,61 volt est représentative d'un défaut de courant USB tandis qu'une tension comprise entre 0,70 volt et 1,16 volt est représentative d'une fourniture de courant de 1,5 ampères par le dispositif source et qu'une tension comprise entre 1,31 volt et 2,04 volts est représentative d'une fourniture de courant de 3 ampères par le dispositif source.

Bien entendu, la présence du pont diviseur de tension 311 ou 312 divise la tension présente à la borne CC1 ou CC2 par 10.

En conséquence, dans le cas présent, une tension au nœud ND1 ou ND2 comprise entre 25 et 65 millivolts sera représentative d'un défaut de courant USB tandis qu'une tension comprise entre 70 et 116 millivolts sera représentative d'une délivrance d'un courant de 1,5 ampère par le dispositif source et qu'une tension comprise entre 131 et 204 millivolts sera représentative d'une délivrance d'un courant de 3 ampères par le dispositif source.

Cela étant, ces valeurs pouvant varier de 25 à 204 millivolts peuvent être facilement mesurées par un convertisseur analogique numérique 32 avec une tension de référence idéalement égale à 2,048 volts, bien qu'une tension de référence de 3 volts soit également possible, en utilisant un convertisseur sur 12 bits ou un convertisseur sur un nombre de bits plus important, donc plus précis.

Comme illustré sur la figure 2, le convertisseur 32 possède deux entrées ADC_inx respectivement connectées aux deux nœuds de sortie ND1, ND2. Mais bien entendu seule l'entrée ADC_inx connectée à la broche CCi effectivement connectée à la broche de configuration de canal du câble, sera opérationnelle.

D'autres modules de mesure de tension sont possibles.

On pourrait ainsi remplacer le convertisseur analogique numérique par un jeu de comparateurs analogiques utilisant différentes tensions de référence de valeurs différentes.

L'information de mesure de tension ainsi que la tension d'alimentation Vin sont transmises à un étage de traitement 33, de structure classique et connue en soi comportant notamment un module de détection de connexion ainsi qu'un contrôleur USB.

## Revendications

1. Dispositif récepteur USB type C, comprenant:
- un port (30) comportant une entrée de configuration de canal (CC1, CC2), une broche de masse (GND), et une broche de tension d'alimentation (VBUS) configurée pour recevoir une tension d'alimentation (Vin),
- un étage de protection contre des hautes tensions sur l'entrée de configuration de canal, dans lequel l'étage de protection comprend un module résistif (31) couplé entre l'entrée de configuration de canal (CC1, CC2) et la borne de masse (GND) et configuré pour former à la fois un diviseur de tension et un circuit résistif de tirage vers le bas couplé entre l'entrée de configuration de canal et la broche de masse,
- un module de mesure de tension (32) couplé à la sortie du diviseur de tension, **caractérisé en ce que** le dispositif comprenant en outre
- un étage de traitement (33) comportant un module de détection de connexion ainsi qu'un contrôleur USB, l'étage de traitement étant configuré pour recevoir la tension d'alimentation (Vin) et une information de mesure de tension du module de mesure de tension.

2. Dispositif selon la revendication 1, dans lequel la valeur résistive du circuit résistif de tirage vers le bas est égale à une valeur nominale à plus ou moins 10% près, l'entrée de configuration de canal (30) comprend deux broches de configuration de canal (CC1, CC2), et le module résistif (31) comprend deux ponts résistifs diviseurs de tension (311, 312) respectivement couplés entre les deux broches de configuration de canal et la borne de masse (GND), chaque pont résistif diviseur de tension comprend un premier élément résistif (R11, R12) couplé à la broche de configuration de canal correspondante (CC1, CC2) et un deuxième élément résistif (R21, R22) couplé entre le premier élément résistif et la borne de masse (GND), la valeur résistive du premier élément résistif (R11, R12) est égale à ladite valeur nominale à plus ou moins 10% près, la valeur résistive du deuxième élément résistif (R21, R22) est non nulle et la somme des valeurs résistives des deux éléments résistifs est égale à ladite valeur nominale à plus ou moins 10% près.

3. Dispositif selon la revendication 2, dans lequel la valeur nominale est égale à 5100 ohms, la valeur résistive du premier élément résistif (R11, R12) est égale à 4590 ohms et la valeur résistive du deuxième élément résistif (R21, R22) est égale à 510 ohms.

4. Dispositif selon l'une des revendications 2 ou 3, dans lequel le module de mesure de tension comprend un convertisseur analogique numérique comportant deux entrées respectivement connectées aux deux sorties (ND1, ND2) des deux ponts résistifs diviseurs de tension.

5. Dispositif selon les revendications 3 et 4, dans lequel le convertisseur analogique numérique est un convertisseur sur au moins 12 bits.

6. Appareil électronique, tel que téléphone portable cellulaire, tablette, ou ordinateur portable, comprenant au moins un dispositif (3) selon l'une des revendications 1 à 5.

## Patentansprüche

1. USB-Empfängervorrichtung vom Typ C, umfassend:
- einen Anschluss (30), umfassend einen Kanalkonfigurationseingang (CC1, CC2), einen Erdungsstift (GND) und einen Versorgungsspannungsstift (VBUS), der ausgestaltet ist, eine Versorgungsspannung (Vin) zu empfangen,
- eine Schutzstufe gegen hohe Spannungen am Kanalkonfigurationseingang, wobei die Schutzstufe ein Widerstandsmodul (31) umfasst, das zwischen den Kanalkonfigurationseingang (CC1, CC2) und den Erdungsstift (GND) gekoppelt und ausgestaltet ist, gleichzeitig einen Spannungsteiler und einen Pulldown-Widerstandsschaltkreis zu bilden, der zwischen den Kanalkonfigurationseingang und den Erdungsstift gekoppelt ist,
- ein Spannungsmessmodul (32), das an den Eingang des Spannungsteilers gekoppelt ist, **dadurch gekennzeichnet, dass** die Vorrichtung weiter umfasst
- eine Verarbeitungsstufe (33), umfassend ein Verbindungserkennungsmodul sowie einen USB-Controller, wobei die Verarbeitungsstufe ausgestaltet ist, die Versorgungsspannung (Vin) und eine Spannungsmessinformation von dem Spannungsmessmodul zu empfangen.

2. Vorrichtung nach Anspruch 1, wobei der Widerstandswert des Pulldown-Widerstandsschaltkreises einem Nennwert auf mehr oder weniger 10 % genau gleich ist, wobei der Kanalkonfigurationseingang (30) zwei Kanalkonfigurationsstifte (CC1, CC2) umfasst und das Widerstandsmodul (31) zwei Spannungsteiler-Widerstandsbrücken (311, 312) umfasst, die jeweils zwischen die zwei Kanalkonfigurationsstifte und den Erdungsstift (GND) gekoppelt sind, wobei jede Spannungsteiler-Widerstandsbrücke ein erstes Widerstandselement (R11, R12), das an den entsprechenden Kanalkonfigurationsstift (CC1, CC2) gekoppelt ist, und ein zweites Widerstandselement (R21, R22), das zwischen das erste Widerstandselement und den Erdungsstift (GND) gekoppelt ist, umfasst, wobei der Widerstandswert des ersten Widerstandselements (R11, R12) dem Nennwert auf mehr oder weniger 10 % genau gleich ist, wobei der Widerstandswert des zweiten Widerstandselements (R21, R22) nicht null ist und die Summe der Widerstandswerte der zwei Widerstandselemente dem Nennwert auf mehr oder weniger 10 % genau gleich ist.

3. Vorrichtung nach Anspruch 2, wobei der Nennwert gleich 5100 Ohm ist, der Widerstandswert des ersten Widerstandselements (R11, R12) gleich 4590 Ohm ist und der Widerstandswert des zweiten Widerstandselements (R21, R22) gleich 510 Ohm ist.

4. Vorrichtung nach einem der Ansprüche 2 oder 3, wobei das Spannungsmessmodul einen Analog-Digital-Wandler umfasst, der zwei Eingänge umfasst, die jeweils mit den zwei Ausgängen (ND1, ND2) der zwei Spannungsteiler-Widerstandsbrücken verbunden sind.

5. Vorrichtung nach den Ansprüchen 3 und 4, wobei der Analog-Digital-Wandler ein Wandler über wenigstens 12 Bit ist.

6. Elektronisches Gerät, wie etwa Mobiltelefon, Tablet oder Laptop, umfassend wenigstens eine Vorrichtung (3) nach einem der Ansprüche 1 bis 5.

## Claims

1. USB Type-C receiver device, comprising:
- a port (30) including a channel configuration input (CC1, CC2), a ground pin (GND), and a power supply voltage pin (VBUS) configured to receive a power supply voltage (Vin),
- a protection stage against high voltages on the channel configuration input, wherein the protection stage comprises a resistive module (31) coupled between the channel configuration input (CC1, CC2) and the ground pin (GND) and configured to form both a voltage divider and a resistive pull-down circuit coupled between the channel configuration input and the ground pin,
- a voltage measurement module (32) coupled with the output of the voltage divider, **characterised in that** the device further comprises
- a processing stage (33) including a connection detection module and a USB controller, the processing stage being configured to receive the power supply voltage (Vin) and a voltage measurement data item from the voltage measurement module.

2. Device according to claim 1, wherein the resistive value of the resistive pull-down circuit is equal to a nominal value within plus or minus 10%, the channel configuration input (30) comprises two channel configuration pins (CC1, CC2), and the resistive module (31) comprises two resistive voltage divider bridges (311, 312) respectively coupled between the two channel configuration pins and the ground pin (GND), each resistive voltage divider bridge comprises a first resistive element (R11, R12) coupled with the corresponding channel configuration pin (CC1, CC2) and a second resistive element (R21, R22) coupled between the first resistive element and the ground pin (GND), the resistive value of the first resistive element (R11, R12) is equal to said nominal value within plus or minus 10%, the resistive value of the second resistive element (R21, R22) is different from zero and the sum of the resistive values of the two resistive elements is equal to said nominal value within plus or minus 10%.

3. Device according to claim 2, wherein the nominal value is equal to 5100 Ohms, the resistive value of the first resistive element (R11, R12) is equal to 4590 Ohms and the resistive value of the second resistive element (R21, R22) is equal to 510 Ohms.

4. Device according to one of claims 2 or 3, wherein the voltage measurement module comprises an analogue/digital converter including two inputs respectively connected to the two outputs (ND1, ND2) of the two resistive voltage divider bridges.

5. Device according to claims 3 and 4, wherein the analogue/digital converter is a converter on at least 12 bits.

6. Electronic appliance, such as a cellular mobile telephone, tablet, or laptop computer, comprising at least one device (3) according to one of claims 1 to 5.
